# EUROPÄISCHE PATENTSCHRIFT

(11) **EP 2 768 926 B1**
(45) Veröffentlichungstag und Bekanntmachung des Hinweises auf die Patenterteilung: **19.09.2018**
(21) Anmeldenummer: 12778082.3
(22) Anmeldetag: 17.10.2012
(51) Int. Cl.: C09K 11/06, H05B 33/14, C07F 1/00, H01L 51/00, H01L 51/50

(54) **ORGANISCHES ELEKTRONISCHES BAUELEMENT MIT DOTIERSTOFF, VERWENDUNG EINES DOTIERSTOFFS UND VERFAHREN ZUR HERSTELLUNG DES DOTIERSTOFFS**
ORGANIC ELECTRONIC COMPONENT WITH DOPANT, USE OF A DOPANT AND METHOD FOR THE PRODUCTION OF THE DOPANT
COMPOSANT ÉLECTRONIQUE ORGANIQUE CONTENANT UN DOPANT, UTILISATION D'UN DOPANT ET PROCÉDÉ DE PRODUCTION D'UN DOPANT

(30) Priorität: 17.10.2011 DE 102011084639
(43) Veröffentlichungstag der Anmeldung: 27.08.2014
(73) Patentinhaber: OSRAM OLED GmbH, 93049 Regensburg (DE)
(72) Erfinder: KANITZ, Andreas, 91315 Höchstadt (DE); KELLERMANN, Renate, 91058 Erlangen (DE); SANDMANN, Benedict Hendrik, 94336 Hunderdorf (DE); SCHMID, Günter, 91334 Hemhofen (DE); WEMKEN, Jan Hauke, 9044p Nürnberg (DE)
(74) Vertreter: Epping - Hermann - Fischer
(86) Internationale Anmeldenummer: PCT/EP2012/070537
(87) Internationale Veröffentlichungsnummer: WO 2013/057130

(56) Entgegenhaltungen:
- JP-A- 7 133 281
- US-A- 5 741 623
- J. R. MCKELLAR ET AL: "Electrical conductivity of some organic materials containing metals", DISCUSSIONS OF THE FARADAY SOCIETY, Bd. 51, 1. Januar 1971 (1971-01-01), Seite 176, XP055045350, ISSN: 0366-9033, DOI: 10.1039/df9715100176
- LOPAMUDRA CHAKRABORTY ET AL: "Synthesis and properties of copper (II), oxovanadium (IV) and gadolinium (III) complexes derived from polar Schiffs bases", JOURNAL OF MOLECULAR STRUCTURE, ELSEVIER, AMSTERDAM, NL, Bd. 1002, Nr. 1, 10. August 2011 (2011-08-10), Seiten 135-144, XP028274222, ISSN: 0022-2860, DOI: 10.1016/J.MOLSTRUC.2011.07.010 [gefunden am 2011-07-17]

## Beschreibung

Es wird ein organisches elektronisches Bauelement angegeben, das einen Dotierstoff enthält, die Verwendung eines Dotierstoffs und ein Verfahren zur Herstellung eines Dotierstoffs.

Effizienz und Lebensdauer von organischen elektronischen Bauelementen wie beispielsweise organischer Leuchtdioden sind unter anderem abhängig von der Qualität der Ladungsträgerinjektion und des Ladungsträgertransports. Mittels Dotierung kann die Leitfähigkeit von Materialien, und damit der Ladungsträgertransport, um Größenordnungen erhöht werden. Die Dotierung organischer Materialien mit Elektronenakzeptoren kann beispielsweise die Leitfähigkeit von Lochleiterschichten erhöhen.

JP 07-133281 A beschreibt Kupfermetallkomplexe mit 10-Hydroxybenzo[h]quinolin-Liganden.

McKellar, J. et al., Discussions of the Faraday Society, Inorganic Chemistry Laboratory Oxford, Bd. 51, pp 176, beschreibt Kupferkomplexe zur Erhöhung der elektrischen Leitfähigkeit in biologischen Systemen.

Aufgabe einer Ausführungsform ist die Bereitstellung eines organischen elektronischen Bauelements, das einen neuen Dotierstoff aufweist. Aufgabe einer weiteren Ausführungsform ist die Bereitstellung der Verwendung eines neuen Dotierstoffs in einem Lochtransportmaterial. Eine weitere Aufgabe ist die Bereitstellung eines Verfahrens zur Herstellung eines Dotierstoffs.

Diese Aufgaben werden durch ein Bauelement gemäß Anspruch 1, die Verwendung gemäß Anspruch 14 und das Verfahren gemäß Anspruch 15 gelöst. Weitere Ausführungsformen des Bauelements und der Verwendung sind Gegenstand abhängiger Ansprüche.

Es wird ein organisches elektronisches Bauelement, das ein Substrat, eine erste Elektrode auf dem Substrat, zumindest eine organische Funktionsschicht, die ein Matrixmaterial, in dem ein p-Dotierstoff eingebracht ist, enthält, auf der ersten Elektrode, und eine zweite Elektrode auf der zumindest einen organischen Funktionsschicht umfasst. Dabei umfasst der p-Dotierstoff einen Kupferkomplex, der zumindest einen Liganden aufweist, der eine Aryloxygruppe und eine Iminiumgruppe enthält, wobei die Aryloxygruppe und die Iminiumgruppe des Liganden eine Salicylaldiminatgruppe sind.

Unter "p-Dotierstoff" ist in diesem Zusammenhang ein Dotierstoff mit Elektronenakzeptor-Eigenschaften zu verstehen, der somit insbesondere Löcher, also positive Ladungsträger bzw. Defektelektronen, beispielsweise auf einem Matrixmaterial, in das er eingebettet sein kann, erzeugen kann. Der Dotierstoff erhöht die Zahl der freien Ladungsträger und damit die Leitfähigkeit, die ein Produkt aus Mobilität und der Zahl der Ladungsträger ist. Unter der Annahme, dass die Mobilität gleich bleibt, erhöht sich bei Dotierung die Leitfähigkeit über die Erhöhung der Zahl der Ladungsträger.

Mit "auf" im Zusammenhang mit der Anordnung der Elemente des Bauelements kann sowohl eine direkte Anordnung als auch eine indirekte Anordnung verstanden werden. Somit können zwei Elemente so aufeinander angeordnet sein, dass sie eine gemeinsame Grenzfläche umfassen, oder dass noch weitere Elemente zwischen ihnen angeordnet sind.

Unter "Kupferkomplex" soll im Folgenden ein metallorganischer Komplex verstanden werden, der ein Kupferkation als Zentralatom enthält, sowie mindestens einen Liganden. Insbesondere kann der Kupferkomplex zwei Liganden aufweisen. Die Aryloxygruppe des zumindest einen Liganden kann mit dem in ihr enthaltenen Sauerstoffatom und die Iminiumgruppe mit dem in ihr enthaltenen Stickstoffatom an das Kupferkation koordiniert oder gebunden sein. Sind zwei Liganden in dem Kupferkomplex vorhanden, kann somit das Kupferkation an zwei Sauerstoffatome und an zwei Stickstoffatome koordiniert oder gebunden sein.

Ein solches Bauelement weist eine Funktionsschicht mit optimiertem Lochtransport und im Vergleich zum Rest des Bauelements niedrig gehaltenem Spannungsabfall und somit eine verbesserte Effizienz auf.

Für den Fall, dass es sich bei dem organischen elektronischen Bauelement um eine organische Leuchtdiode handelt, kann der p-Dotierstoff in der zumindest einen Funktionsschicht zudem das Erscheinungsbild der Leuchtdiode im ausgeschalteten Zustand (die sogenannte "Off-State-Appereance") beeinflussen. Der p-Dotierstoff ist so gestaltet, dass die Farbe der Funktionsschicht, in der er eingebracht ist, in Abhängigkeit der Konzentration des p-Dotierstoffs modifiziert werden kann, ohne die elektrische Leitfähigkeit der Funktionsschicht zu verändern.

Bislang sind organische Leuchtdioden so gestaltet, dass beispielsweise rötliche Lochleiterschichten, die teilweise blaues und grünes Licht absorbieren, optisch so kompensiert werden, dass die Dioden im eingeschalteten Zustand ein angenehmes weißes Licht emittieren. Mit dem neuen p-Dotierstoff kann der Leuchtdiode auch im ausgeschalteten Zustand, ein optischer Farbeindruck gegeben werden, wenn die Funktionsschicht beispielsweise an eine transparente Elektrode grenzt.

Gemäß einer Weiterbildung sind die Aryloxygruppe und die Iminiumgruppe des Liganden eine Salicylaldiminatgruppe. Unter Salicylaldiminatgruppe ist ein Ligand zu verstehen, der aus einem Salicylaldehyd und einem aromatischen Mono- oder Diamin oder einem olefinischen Mono- oder Diamin gebildet ist. Somit umfasst der Ligand eine aminkondensierte Salicylaldehydgruppe und ist zur Komplexierung zwischen Aryloxygruppe und dem Stickstoff der Iminiumgruppe, beispielsweise einer Azomethingruppe, befähigt. Damit werden im Vergleich zu bislang verwendeten p-Dotierstoffen kostenreduzierte p-Dotierstoffe bereitgestellt.

Weist der Kupferkomplex zwei solcher Liganden auf, können diese aufgrund ihrer Struktur so an das Kupferkation koordiniert sein, dass der Kupferkomplex eine cis-Struktur oder eine trans-Struktur aufweist. Der Kupferkomplex mit cis-Struktur kann sich in einen Kupferkomplex mit trans-Struktur umwandeln. Mittels Temperatur, Druck und Wahl des Lösungsmittels kann die Synthese des Kupferkomplexes so gesteuert werden, dass sich bevorzugt ein Isomer, cis- oder trans-Struktur, bildet.

Weiterhin kann das Kupferkation in dem Kupferkomplex in der Oxidationsstufe II enthalten sein. Im Folgenden wird daher auch die Schreibweise Cu^{II} verwendet.

Gemäß einer weiteren Ausführungsform kann der Kupferkomplex eine der allgemeinen Formeln I oder II aufweisen:

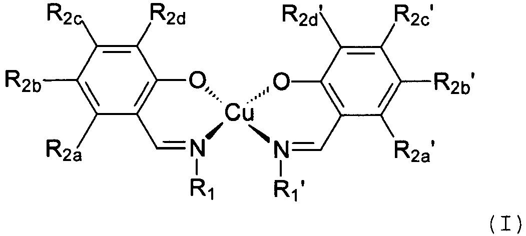

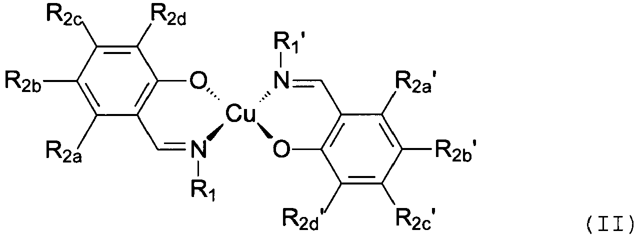

Formel (I) stellt ein cis-Isomer des Kupferkomplexes dar, Formel (II) ein trans-Isomer. Ein solcher Kupferkomplex enthält somit zwei Liganden, die an das Kupferkation koordiniert bzw. gebunden sind.

In den Formeln (I) und (II) gilt: R₁, R_{1'}, R₂ₓ und R_{2x'} (wobei x jeweils für a, b, c oder d steht) sind unabhängig voneinander ausgewählt aus einer Gruppe, die unverzweigte, verzweigte, kondensierte, ringförmige, unsubstituierte und substituierte Alkylreste, substituierte und unsubstituierte Aromaten, substituierte und unsubstituierte Heteroaromaten umfasst.

Beispiele für solche Substituenten sind Methylgruppen, Ethylgruppen, Decahydronaphthylgruppen, Cyclohexylgruppen und Alkylreste die oder teilweise substituiert und bis zu 20 Kohlenstoffatome aufweisen können. Diese Alkylreste können weiterhin Ethergruppen, wie Ethoxy- oder Methoxygruppen, Estergruppen, Amidgruppen, Carbonatgruppen oder auch Halogene, insbesondere F, enthalten.

Beispiele für substituierte oder unsubstituierte Aromaten sind Phenyl, Diphenyl, Naphthyl, Phenanthryl oder Benzyl.

Beispiele möglicher Heteroaromaten sind in folgender Tabelle 1 genannt. Der Einfachheit halber ist nur jeweils der Grundkörper der Heteroaromaten dargestellt. Prinzipiell kann dieser Grundkörper mit weiteren Resten R substituiert sein, die analog den oben definierten Resten R₁, R_{1'}, R₂ₓ und R_{2x'} ausgeformt sein können. Die Bindung an den Liganden kann an jeder bindungsfähigen Stelle des Grundkörpers erfolgen.

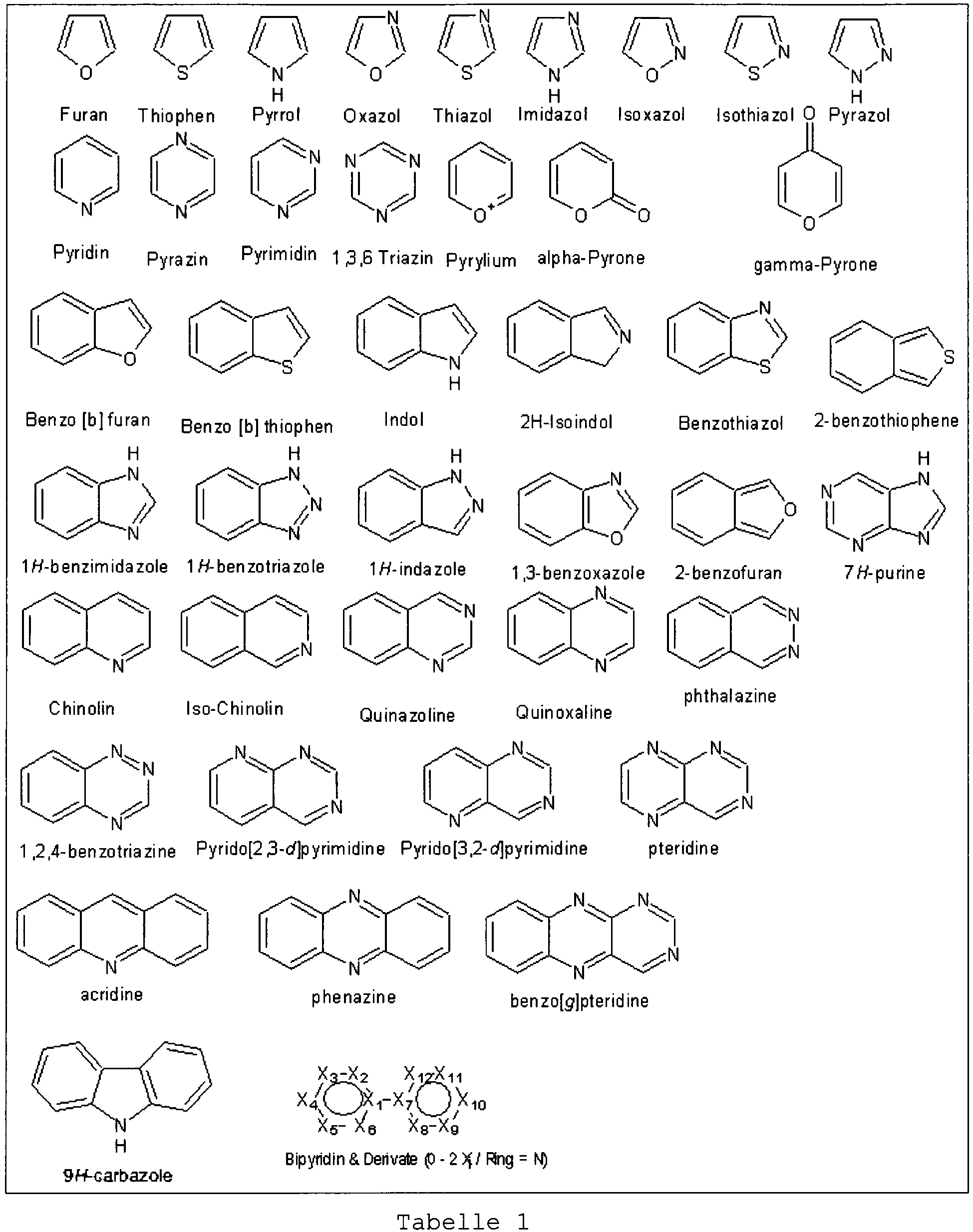

Weiterhin können die Substituenten in den allgemeinen Formeln (I) und (II) in den beiden Liganden gleich oder verschieden sein. Gemäß einer Ausführungsform sind R₁ und R_{1'} und R₂ₓ und R_{2x'} jeweils gleich. Werden die Substituenten gleich gewählt, ist die Synthese des Kupferkomplexes besonders einfach durchzuführen, was auch eine Kostenreduzierung bedingt.

Weiterhin können R₁ und R_{1'} miteinander verbunden sein. Somit kann zwischen den beiden Liganden, die an das Kupferkation koordiniert bzw. gebunden sind, eine Brücke ausgebildet sein. Solche Ausführungsformen sind in den allgemeinen Formen (Ia) und (IIa) dargestellt.

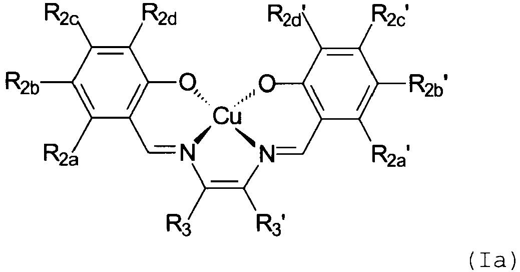

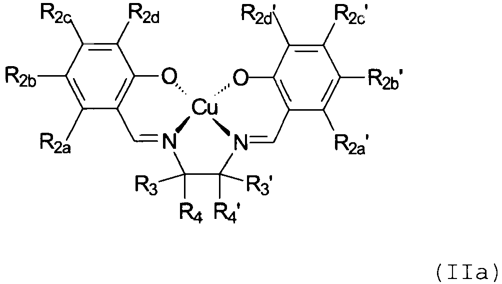

Formeln (Ia) und (IIa) stellen jeweils cis-Isomere des verbrückten Kupferkomplexes dar. Prinzipiell ist eine Verbrückung auch bei trans-Isomeren denkbar, wenn eine entsprechend lange Brücke zwischen R₁ und R_{1'} gewählt wird. Für die Reste R₃, R_{3'}, R₄ und R_{4'} gelten die Definitionen für die Reste R₁, R_{1'}, R₂ₓ und R_{2x'} analog.

Kupferkomplexe, die eine der genannten allgemeinen Formeln (I), (Ia), (II) oder (IIa) aufweisen, können aufgrund ihrer Lewis-Acidität gut als p-Dotierstoffe eingesetzt werden, da sie elektronenziehende Liganden aufweisen und somit ihre Elektronenakzeptor-Eigenschaften verstärkt werden. Damit wird die Lochleitfähigkeit in der organischen Funktionsschicht des organischen elektronischen Bauelements verbessert.

Gemäß einer weiteren Ausführungsform kann zumindest einer aus R₁, R_{1'}, R₂ₓ und R_{2x'} sowie - wenn vorhanden - aus R₃, R_{3'}, R₄ und R_{4'} einen elektronenziehenden Substituenten aufweisen.

Ein elektronenziehender Substituent, wie beispielsweise ein Fluoratom F, kann direkt am Bindungskohlenstoff von zumindest einem der Reste R₁, R_{1'}, R₂ₓ und R_{2x'} sowie - wenn vorhanden - aus R₃, R_{3'}, R₄ und R_{4'} enthalten sein. Ein solcher Rest kann beispielsweise eine der allgemeinen Formeln (IIIa) oder (IIIb) aufweisen:

-(CF₂)ₙ-R₁₀ (IIIa)

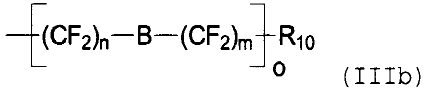

In der Formel (IIIa) kann n = 1 bis 20 sein, R₁₀ kann ein Fluoratom F sein. Gemäß einer Variante ist n = 2 und R₁₀ = F. R₁₀ kann auch wie die Reste R₁, R₂ₓ, R₃ und R₄ ausgewählt werden. Besonders bevorzugt sind hier aliphatische Ketten und Aromaten.

In Formel (IIIb) können n, m und o unabhängig voneinander 0 bis 20 sein, insbesondere können n = m = 2 und o im Bereich von 1 bis 5 ausgewählt werden. R₁₀ kann F und B kann O sein. Alternativ kann B auch aus S, Se, NH, N-R, PH und P-R ausgewählt sein, wobei R gemäß R₁, R₂ₓ, R₃ und R₄ ausgewählt sein kann. Ansonsten kann R₁₀ wie die Reste R₁, R₂ₓ, R₃ und R₄ ausgewählt werden. Besonders bevorzugt sind hier aliphatische Ketten und Aromaten.

Weiterhin kann ein elektronenziehender Substituent auch an einem aromatischen Rest R₁, R₂ₓ, R₃ und R₄ vorhanden sein. Beispiele für solche Reste sind in den allgemeinen Formeln (IIIc) und (IIId) gezeigt:

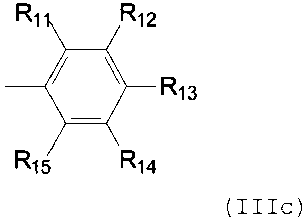

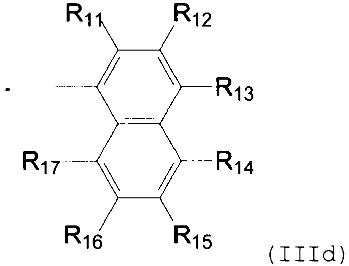

In den Formeln (IIIc) und (IIId) können R₁₁ bis R₁₇ unabhängig voneinander aus einer Gruppe ausgewählt sein, die H, F, CF₃, CN und NO₂ umfasst. Weiterhin können R₁₁ bis R₁₇ unabhängig voneinander wie die Reste R₁, R₂ₓ, R₃ und R₄ gewählt werden.

Insbesondere können sie ganz oder teilweise fluorierte Systeme umfassen.

Elektronenziehende Substituenten in den Resten R₁, R₂ₓ und - wenn vorhanden - R₃ und R₄ können den lochleitenden Charakter der Reste weiter verstärken, da sie die Elektronen ziehende Wirkung des Liganden noch erhöhen, so dass p-Dotierstoffe, die elektronenziehende Substituenten in den Liganden aufweisen, besonders gut die elektrische Leitfähigkeit der Funktionsschicht, in der sie eingebracht sind, erhöhen.

Die zumindest eine organische Funktionsschicht kann Loch leitende sein. Beispielsweise kann sie eine Lochtransportschicht oder eine Lochinjektionsschicht sein.

Das Matrixmaterial der Funktionsschicht kann ein Lochtransportmaterial sein, das organische kleine Moleküle, Polymere oder Mischungen daraus umfasst.

Ist das Lochtransportmaterial aus kleinen Molekülen ausgewählt, können diese beispielsweise aus einer Gruppe ausgewählt sein, die N,N'-Bis(naphthalen-1-yl)-N,N'-bis(phenyl)-9,9-dimethyl-fluoren, N,N'-Bis(3-methylphenyl)-N,N'-bis(phenyl)-9,9-diphenyl-fluoren, N,N'-Bis(naphthalen-1-yl)-N,N'-bis(phenyl)-9,9-diphenyl-fluoren, N,N'-Bis(naphthalen-1-yl)-N,N'-bis(phenyl)-2,2-dimethylbenzidin, N,N'-Bis(3-methylphenyl)-N,N'-bis(phenyl)-9,9-spirobifluoren, 2,2',7,7'-Tetrakis(N, N-diphenylamino)-9,9'-spirobifluoren, N,N'-Bis(naphthalen-1-yl)-N,N'-bis(phenyl)-benzidin, N,N'-Bis(naphthalen-2-yl)-N,N'-bis(phenyl)-benzidin, N,N'-Bis(3-methylphenyl)-N,N'-bis(phenyl)-benzidin, N,N'-Bis(3-methylphenyl)-N,N'-bis(phenyl)-9,9-dimethyl-fluoren, N,N'-Bis(naphthalen-1-yl)-N,N'-bis(phenyl)-9,9-spirobifluoren, Di-[4-(N,N-ditolyl-amino)-phenyl]cyclohexan, 2,2',7,7'-Tetra(N,N-di-tolyl)amino-spiro-bifluoren, 9,9-Bis[4-(N,N-bis-biphenyl-4-yl-amino)phenyl]-9H-fluoren, 2,2',7,7'-Tetrakis[N-naphthalenyl(phenyl)-amino]-9,9-spirobifluoren, 2,7-Bis[N,N-bis(9,9-spiro-bifluorene-2-yl)-amino]-9,9-spirobifluoren, 2,2'-Bis[N,N-bis(biphenyl-4-yl)amino]-9,9-spirobifluoren, N,N'-bis(phenanthren-9-yl)-N,N'-bis(phenyl)-benzidin, N,N,N',N'-Tetra-naphthalen-2-yl-benzidin, 2,2'-Bis(N,N-di-phenyl-amino)-9,9-spirobifluoren, 9,9-Bis[4-(N,N-bis-naphthalen-2-yl-amino)phenyl]-9H-fluoren, 9,9-Bis[4-(N, N'-bis-naphthalen-2-yl-N,N'-bis-phenyl-amino)-phenyl]-9H-fluoren, Titanoxidphthalocyanin, Kupferphthalocyanin, 2,3,5,6-Tetrafluoro-7,7,8,8,-tetracyano-quinodimethan, 4,4',4"-Tris(N-3-methylphenyl-N-phenyl-amino)triphenylamin, 4,4',4"-Tris(N-(2-naphthyl)-N-phenyl-amino)triphenylamin, 4,4',4"-Tris(N-(1-naphthyl)-N-phenyl-amino)triphenylamin, 4,4',4"-Tris(N,N-diphenyl-amino)triphenylamin, N,N'-Di-[(1-naphthyl)-N,N'-diphenyl]-1,1'-biphenyl)-4,4'-diamin, Pyrazino[2,3-f][1,10]phenanthroline-2,3-dicarbonitril, N,N,N',N'-Tetrakis(4-methoxyphenyl)benzidin, 2,7-Bis[N,N-bis(4-methoxy-phenyl)amino]-9,9-spirobifluoren, 2,2'-Bis[N,N-bis(4-methoxy-phenyl)amino]-9,9-spirobifluoren, N,N'-di(naphthalen-2-yl)-N,N'-diphenylbenzol-1,4-diamin, N,N'-di-phenyl-N,N'-di-[4-(N, N-di-tolyl-amino)phenyl]benzidin und N,N'-Di-phenyl-N,N'-di-[4-(N,N-diphenyl-amino)phenyl]benzidin umfasst.

Polymere Lochtransportmaterialien können aus einer Gruppe ausgewählt sein, die PEDOT (Poly(3,4-ethylendioxythiophen), PVK (Poly(9-vinylcarbazol), PTPD (Poly(N,N'-bis(4-butylphenyl)-N,N'-bis(phenyl)-benzidin), P3HT (Poly(3-hexylthiophen) und PANI (Polyanilin) umfasst. Diese Wiederholeinheiten dieser beispielhaften polymeren Materialien sind in den Formeln (IVa) bis (IVe) wiedergegeben:

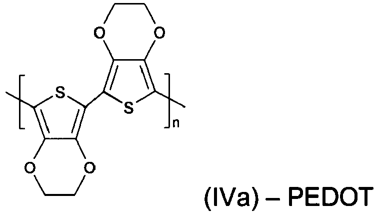

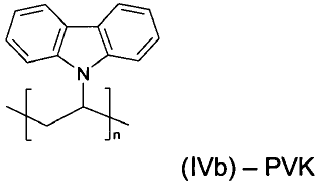

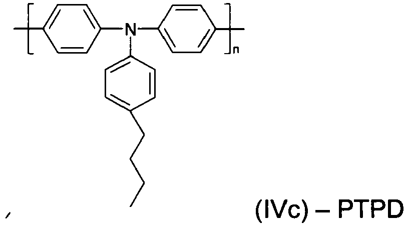

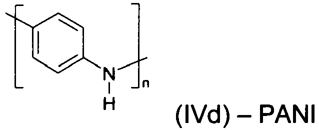

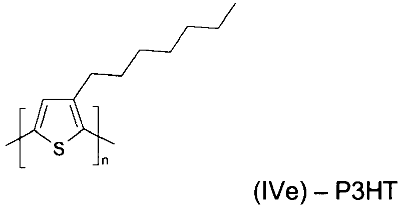

Liegt eine Mischung aus kleinen Molekülen und polymeren Lochtransportmaterialien vor, kann das Mischungsverhältnis zwischen 0 und 100% liegen.

Die oben genannten p-Dotierstoffe können mit einer Konzentration von 0,1 bis 50 Vol%, insbesondere mit einer Konzentration von 2 bis 30 Vol%, in dem Matrixmaterial vorhanden sein.

Wird eine organische Funktionsschicht, beispielsweise ein Lochtransportschicht hergestellt, können die Materialien, also das Matrixmaterial, in dem der p-Dotierstoff eingebettet ist, aus der Gasphase oder aus der Flüssigphase abgeschieden werden. Enthält das Matrixmaterial kleine Moleküle, kann die Abscheidung aus der Flüssigphase oder aus der Gasphase erfolgen, werden polymere Materialien ausgewählt, können diese aus der Flüssigphase abgeschieden werden. Die Filmbildungseigenschaften bei der Herstellung der Funktionsschicht bei der Verarbeitung aus der Flüssigphase können verbessert werden, wenn eine Mischung aus kleinen Molekülen und polymeren Materialien als Matrixmaterial verwendet werden.

Als Lösungsmittel können für die Abscheidung aus der Flüssigphase organische Lösungsmittel verwendet werden, die beispielsweise aus einer Gruppe ausgewählt sind, die Chlorbenzol, Chloroform, Toluol, THF und Methoxypropylacetat umfasst.

Gemäß einer Ausführungsform können Moleküle des p-Dotierstoffs von jeweils zumindest einem Molekül des Matrixmaterials koordiniert sein. Beispielsweise kann die Dotierung des Matrixmaterials dadurch erfolgen, dass ein bis zwei Lochtransportmaterial-Moleküle in die axialen Positionen des Kupferkomplexes koordiniert sind. Die quadratisch planare Koordinationsumgebung des Dotierstoffs kann somit über die tetragonale Pyramide (ein Matrixmaterialmolekül) zum Oktaeder (zwei Matrixmaterialmoleküle) erweitert werden. Prinzipiell ist es auch möglich, dass zwei Dotierstoffmoleküle über ein bifunktionelles Matrixmaterialmolekül verbrückt werden.

Am Beispiel von NPB (N,N'-Di-[(1-naphthyl)-N,N'-diphenyl]-1,1'-biphenyl)-4,4'-diamin) als Matrixmaterial und einem schematisch angedeuteten Kupferkomplex, in dem nur die jeweils zwei Bindungen von dem Kupferkation zu den Liganden gezeigt sind, ist eine solche Koordination im Schema 1 gezeigt:

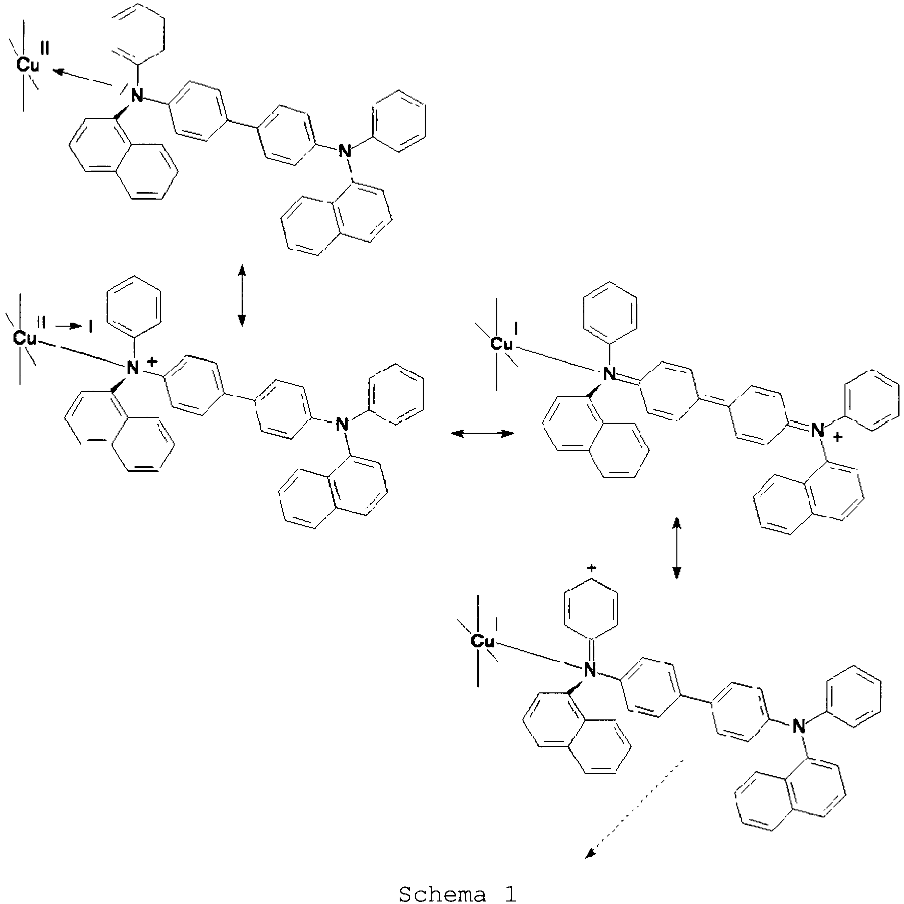

Die Koordination erfolgt über eine Wechselwirkung zwischen dem Stickstoffatom des NPB und dem Kupferkation, so dass eine positive Ladung des Kupferkations delokalisiert werden kann. Diese Delokalisation, die auch auf andere Loch transportierende Moleküle übergehen kann, ist durch die vier beispielhaften Grenzstrukturen des Schemas 1 dargestellt, welche jedoch nur formal zu verstehen sind.

Das Bauelement gemäß den obigen Ausführungen kann aus einer Gruppe ausgewählt sein, die Feldeffekttransistoren, Solarzellen, Photodetektoren, optoelektronische Bauelemente, Licht emittierende Dioden und Displays umfasst. Insbesondere kann das Bauelement eine organische Licht emittierende Diode (OLED) sein. Die Funktionsschicht kann, insbesondere in OLEDs als Lochtransportschicht, die nahe einer Elektrode, beispielsweise der Anode, angeordnet sein kann, und/oder als lochleitende Teilschicht einer ladungserzeugenden Schichtfolge (Charge-Generation-Layer, CGL) ausgeformt sein.

Unter einer ladungserzeugenden Schichtfolge kann eine Kombination von benachbarten n- und p-dotierten organischen Teilschichten verstanden werden. Durch eine ladungserzeugende Schichtfolge können zueinander benachbarte organische Funktionsstapel, die beispielsweise jeweils Funktionsschichten und emittierende Schichten enthalten können, miteinander verbunden werden, wobei durch die ladungserzeugende Schichtfolge in die benachbarten organischen Funktionsstapel Ladungsträger injiziert werden können.

Dadurch, dass die Bauelemente einen p-Dotierstoff gemäß den obigen Ausführungen umfassen, sind sie kostengünstiger herstellbar und weisen einen optimierten Ladungstransport auf. Insgesamt kann das Bauelement somit eine verbesserte Effizienz und Lebensdauer aufweisen. Im Falle von OLEDs kann zudem durch die Verwendung des p-Dotierstoffs das Erscheinungsbild im ausgeschalteten Zustand modifiziert werden, so dass die OLED nicht mehr wie herkömmlich grau erscheint, sondern auf einen äußeren Betrachter einen farbigen Eindruck macht.

Es wird weiterhin die Verwendung eines Kupferkomplexes, der zumindest einen Liganden aufweist, der eine Aryloxygruppe und eine Iminiumgruppe enthält, als p-Dotierstoff in einem Lochtransportmaterial angegeben. Die Aryloxygruppe und die Iminiumgruppe des Liganden sind eine Salicylaldiminatgruppe. Insbesondere kann der Kupferkomplex eine der allgemeinen Formeln I oder II aufweisen: 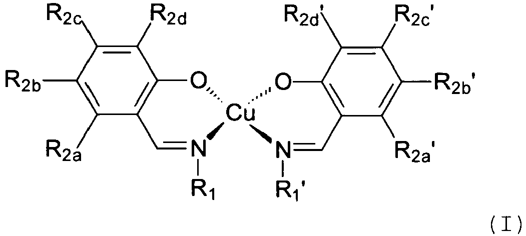 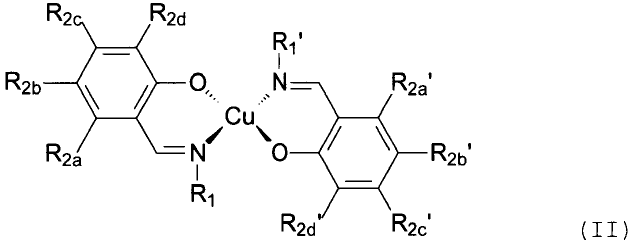 wobei
R₁, R_{1'}, R₂ₓ, R_{2x'} mit x = a, b, c oder d, unabhängig voneinander ausgewählt sind aus einer Gruppe, die unverzweigte, verzweigte, kondensierte, ringförmige, unsubstituierte und substituierte Alkylreste, substituierte und unsubstituierte Aromaten, substituierte und unsubstituierte Heteroaromaten umfasst.

In weiteren Ausführungsformen kann der Kupferkomplex analog zu den Ausführungen bezüglich des p-Dotierstoffs, der in dem organischen elektronischen Bauelement vorhanden ist, ausgeformt sein. Als Lochtransportmaterialien, in denen der p-Dotierstoff verwendet wird, können beispielsweise die in Bezug auf das organische elektronische Bauelement genannten Lochtransportmaterialien gewählt werden.

Die Verwendung eines solchen Kupferkomplexes als p-Dotierstoff in Lochtransportmaterialien, erhöht deren Leitfähigkeit um Größenordnungen. Dies wird zumindest teilweise durch seine Lewis-Säure-Eigenschaften bewirkt. Zudem ist die Verwendung eines solchen Kupferkomplexes als p-Dotierstoff besonders kostengünstig, da der Kupferkomplex aus kostengünstigen Ausgangsmaterialien und mittels eines einfach durchzuführenden Verfahrens herstellbar ist.

Weiterhin wird ein Verfahren zur Herstellung eines p-Dotierstoffs, der einen Kupferkomplex mit zumindest einem Liganden, der eine Aryloxygruppe und eine Iminiumgruppe enthält, umfasst, bei dem der zumindest eine Ligand synthetisiert wird und gleichzeitig ein Kupferkation komplexiert wird, angegeben. Die Aryloxygruppe und die Iminiumgruppe des Liganden sind eine Salicylaldiminatgruppe. Ein solches Verfahren ist zum einen kostengünstig aufgrund der verwendeten Ausgangsmaterialien und zum anderen besonders einfach durchführbar.

Die gleichzeitige Synthese des Liganden und des Komplexes kann auch als Template-Synthese bezeichnet werden, was bedeutet, dass nur eine einstufige Reaktion durchgeführt werden muss, um Liganden und den Komplex mit dem Liganden herzustellen. Analoges gilt auch für die Herstellung von Kupferkomplexen mit mehr als einem Liganden.

Gemäß einer Ausführungsform des Verfahrens wird ein fluoriertes oder unfluoriertes Salicylaldehyd und ein fluoriertes oder unfluoriertes Amin, das aus einer Gruppe ausgewählt ist, die aromatische Monoamine, olefinische Monoamine, aromatische Diamine und olefinische Diamine enthält, mit einem Kupfersalz umgesetzt. Insbesondere kann ein Kupfer(II)-Salz eingesetzt werden. Beispiele für Kupfer(II)-Salze sind CuCl₂, CuBr₂ oder Cu-Acetat. Zur Aufreinigung können die erhaltenen Verbindungen sublimiert werden.

Schema 2 zeigt eine Ausführungsform des Verfahrens, bei dem Salicylaldehyd mit einem olefinischen Diamin und einem Kupfersalz zu einem Kupferkomplex, dessen beiden Liganden verbrückt sind, umgesetzt wird (Route 1, oberhalb des Reaktionspfeils) und mit einem olefinischen Monoamin und einem Kupfersalz zu einem Kupferkomplex mit zwei nicht verbrückten Liganden umgesetzt wird (Route 2, unterhalb des Reaktionspfeils) :

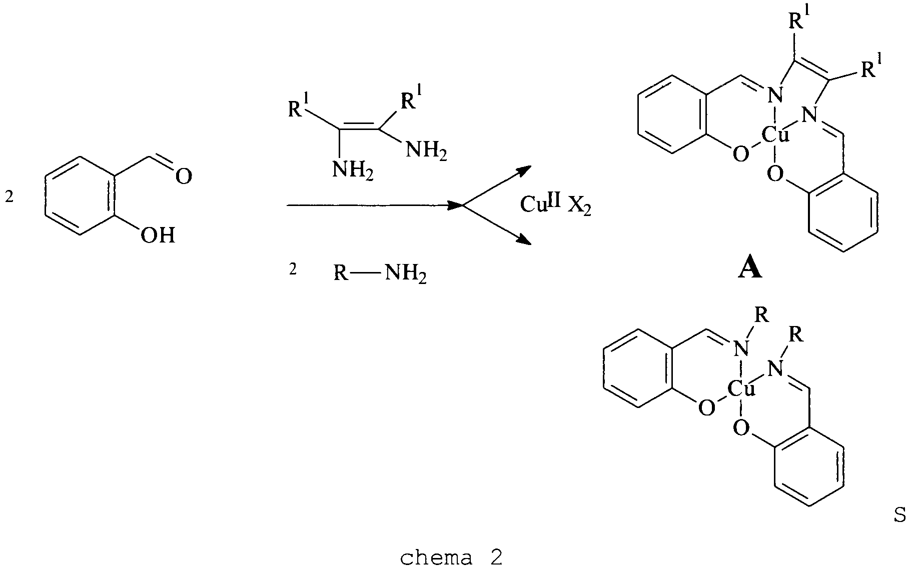

R und R¹ können dabei analog den oben in Bezug auf den p-Dotierstoff des organischen elektronischen Bauelements angegebenen Resten R₁, R₂ₓ sowie, wenn vorhanden R₃ und R₄ ausgewählt sein. Die durch Route 1 und Route 2 erhaltenen Produkte sind mit A gekennzeichnet. Cu^{II}X₂ steht für ein Kupfersalz, das beispielsweise aus CuCl₂, CuBr₂ oder Cu-Acetat ausgewählt sein kann.

Die Reaktion verläuft spontan und ist daher einfach durchführbar.

Anhand der Figuren und Ausführungsbeispiele soll die Erfindung noch näher erläutert werden. In den Figuren sind gleiche Elemente mit gleichen Bezugszeichen gekennzeichnet. Die Figuren sind nicht maßstabsgetreu zu verstehen.
- Figur 1a: zeigt die schematische dreidimensionale Ansicht einer organischen Leuchtdiode,
- Figur 1b: zeigt die schematische Seitenansicht einer organischen Leuchtdiode,
- Figur 2: zeigt die IV-Kennlinien von dotierten Lochtransportschichten gemäß einer ersten Ausführungsform
- Figur 3: zeigt Leitfähigkeiten von dotierten Lochtransportschichten gemäß einer ersten Ausführungsform in Abhängigkeit der Dotierstoffkonzentration
- Figur 4: zeigt Absorptionsspektren der dotierten Lochtransportschichten gemäß der ersten Ausführungsform
- Figur 5: zeigt Photolumineszenzspektren der dotierten Lochtransportschichten gemäß der ersten Ausführungsform
- Figur 6: zeigt Reflexionsspektren der dotierten Lochtransportschichten gemäß der ersten Ausführungsform
- Figur 7: zeigt IV-Kennlinien von dotierten Lochtransportschichten gemäß einer zweiten Ausführungsform
- Figur 8: zeigt Leitfähigkeiten einer zweiten Ausführungsform von dotierten Lochtransportschichten in Abhängigkeit der Dotierstoffkonzentration
- Figur 9: zeigt Absorptionsspektren der dotierten Lochtransportschichten gemäß der zweiten Ausführungsform
- Figur 10: zeigt Photolumineszenzspektren der dotierten Lochtransportschichten gemäß der ersten Ausführungsform
- Figur 11: zeigt Reflexionsspektren der dotierten Lochtransportschichten gemäß der ersten Ausführungsform

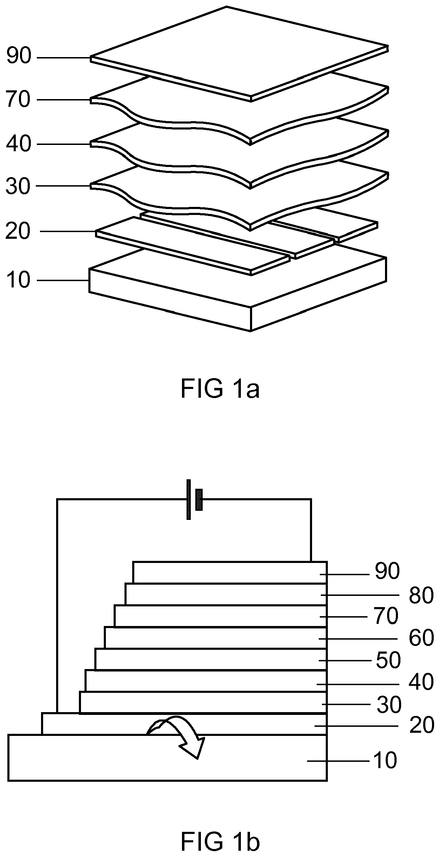

Figuren 1a) und 1b) zeigen eine schematische dreidimensionale und eine schematische zweidimensionale Seitenansicht einer OLED. Auf einem Substrat 10 ist eine erste Elektrode 20 aufgebracht. In Figur 1a) ist angedeutet, dass diese Elektrode strukturiert sein kann. Auf der ersten Elektrode 20 ist eine Lochinjektionsschicht 30, darauf eine Lochtransportschicht 40, eine Emissionsschicht 50, die ein Wirtsmaterial und ein Emissionsmaterial aufweisen kann, eine Lochblockierschicht 60, eine Elektronentransportschicht 70 und eine Elektroneninjektionsschicht 80 aufgebracht. Abschließend ist eine zweite Elektrode 90, die in diesem Beispiel als Kathode ausgeführt ist, aufgebracht. In Figur 1a) sind der Übersichtlichkeit halber nicht alle Schichten gezeigt. Eine OLED muss auch nicht alle Schichten zwischen erster und zweiter Elektrode 10, 90 enthalten. Zudem können OLEDs gemäß den Figuren 1a) und 1b) gestapelt sein und über ladungserzeugende Schichtfolgen miteinander verbunden sein (hier nicht gezeigt).

In Figur 1b) wird weiterhin gezeigt, dass zwischen erster Elektrode 10 und zweiter Elektrode 90 eine Spannung angelegt wird. Diese führt zur Erzeugung von Excitonen und damit zur Emission von elektromagnetischer Strahlung, die insbesondere im sichtbaren Wellenlängenbereich liegt. Der Pfeil in Figur 1b) deutet die Richtung an, in der die Strahlung aus dem Bauelement heraus emittiert wird. In diesem Fall wird die Strahlung durch das Substrat 10 hindurch emittiert. Eine Emission aus der zweiten Elektrode 90 hindurch ist ebenso denkbar. Auch beidseitige Emissionen können realisiert werden.

Beispielhafte Materialien für die in Figur 1a) und 1b) gezeigten Schichten sind unter anderem Glas für das Substrat 10, ITO (Indium Zinnoxid) oder Silizium für die erste Elektrode 20 und Aluminium für die zweite Elektrode 90. Weitere Materialien, die in den Schichten einer OLED eingesetzt werden können, sind dem Fachmann bekannt und werden somit hier nicht näher erläutert.

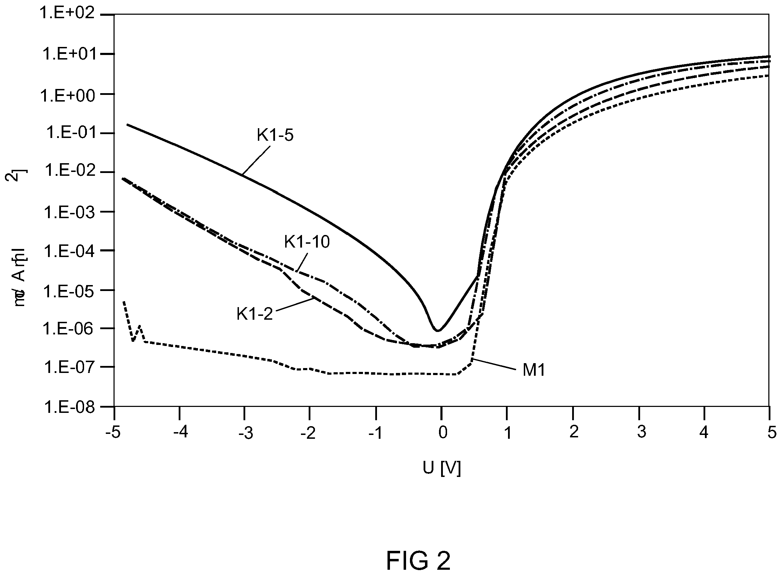

Im Folgenden werden einige Ausführungsbeispiele zu Synthesen von erfindungsgemäßen Kupferkomplexen angegeben:
1) Kupfer-II-(N,N'-2,3-buten-1,4-dinitril-2,3-diyl)-di-salicylaldiminat (im Folgenden als K1 bezeichnet)
   Es wird ein Gemisch aus Cu(CH₃COO)₂ (0,04 mol; 7,99 g) und Ethanol (300 ml) vorgelegt und in der Wärme gerührt bis das komplette Cu(CH₃COO)₂ gelöst ist. In einem 2. Reaktionsansatz werden die Stoffe Salicylaldehyd (0,021 mol; 2,63 g), Diaminomaleonitril (0,04 mol; 4,32 g) und Ethanol (150 ml) vorgelegt und ebenfalls gelöst. Nachdem beide Lösungen vereint und über Nacht refluxiert wurden, scheidet sich ein rötlich-schwarzer Feststoff ab, der abfiltriert wird (Ausbeute Rohprodukt: 5,65 g entsprechend 38%). Das Rohprodukt wird durch Umkristallisation mit DMF (300 ml) und anschließender Fällung mit Ethanol/Diethylether aufgereinigt. Der so erhaltene Reinstoff wird nochmals mit EtOH umkristallisiert, getrocknet und bei 220°C (10⁻⁵ mbar) sublimiert. 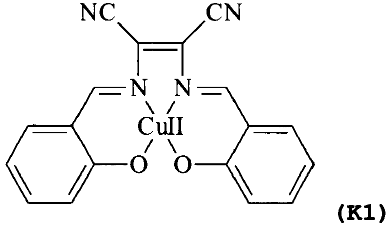
2) Kupfer-II-(bis-N,N'-4-tolyl)-di-salicylaldiminat (im Folgenden als K2 bezeichnet)
   Es wird Cu(CH₃COO)₂ (0,0233 mol; 4,66 g) in Ethanol (120 ml) gelöst. Als separate Lösung werden p-Toluidin (0,047 mol; 5 g) und Salicylaldehyd (0,047 mol; 5,7 g) und Ethanol (120 ml) vorgelegt und gelöst. Die beiden Mischungen werden vereint und über Nacht bei Raumtemperatur gerührt. Die Suspension wird etwas eingeengt und anschließend wird der braun-schwarze Niederschlag abfiltriert und getrocknet. Die Ausbeute an Rohprodukt beträgt 9,95 g (entsprechend 87,5%).
   Die Substanz (Smp.: 205°C) wird bei 180 °C (10⁻⁵ mbar) und anschließend nochmals bei 170°C (10⁻⁵ mbar) sublimiert. 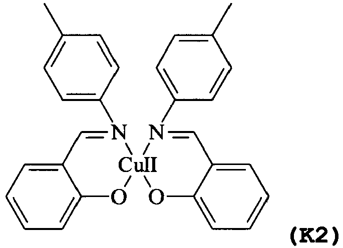
3) Kupfer-II-bis(N,N'-4-butyl)-disalicylaldiminat (im Folgenden K3)
   Salicylaldehyd (S) und Butylamin (B) kondensieren in Gegenwart des Kupfersalze in ethanolischer Lösung ohne protische Katalyse zum Aldiminderivat, welches nach der Bildung sofort in die Ligandensphäre des Kupfers eingeführt wird: 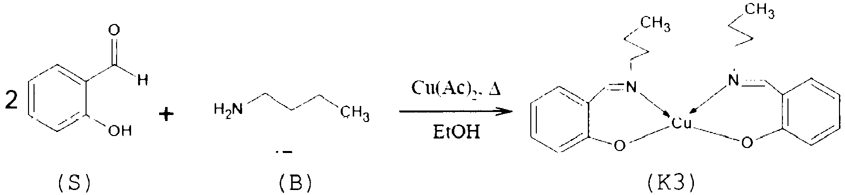
   K3 hat einen Schmelzpunkt von 79°C und sublimiert bei 79°C bis 81°C. Die Ausbeute beträgt 19,8 g (entsprechend 70%).
   Anhand der folgenden Ausführungsbeispiele werden verschiedene elektrische und optische Eigenschaften der p-Dotierstoffe K1 bis K3 gezeigt.
4) Auf einer ITO Elektrode 20 wird durch thermisches Verdampfen eine 200 nm dicke Schicht des Lochleiters 1-TNATA (4,4',4"-Tris(N-(1-naphthyl)-N-phenyl-amino)triphenylamin) abgeschieden (Vergleichsbeispiel M1). Als Gegenelektrode 90 dient eine 150 nm dicke Aluminiumschicht. In drei weiteren Experimenten wird der Dotierstoff K1 in Konzentrationen von 2% (K1-2), 5% (K1-5) und 10% (K1-10) relativ zur Verdampfungsrate in 1-TNATA, dem Matrixmaterial, eindotiert.
   Ein 4 mm² großes Bauelement ergibt jeweils die in Figur 2 gezeigten Strom-Spannungs-Kennlinien (IV-Kennlinien). Es ist der Strom I in [mA/cm²] gegen die Spannung U in [V] aufgetragen. Das Bauelement mit 2% Konzentration ergab dabei die mit K1-2 gekennzeichnete Kennlinie, das Bauelement mit 5% Konzentration die mit K1-5 markierte Kennlinie und das Bauelement mit 10% Konzentration die mit K1-10 gekennzeichnete Kennlinie. Zum Vergleich ist die IV-Kennlinie des reinen Matrixmaterials, gekennzeichnet mit M1, gezeigt. Für alle Konzentrationen kann gezeigt werden, dass die Dotierung einen Effekt auf die IV-Kennlinie hat. Es zeigt sich für alle 3 Konzentrationen ein Anstieg der Stromdichten im Vergleich zum Vergleichsbeispiel M1. Hierbei zeigt sich weiterhin, dass der Dotiereffekt abhängt von der Dotierstoffkonzentration und bei 5% Konzentration die höchste Stromdichte erreicht. Es ist zwar kein ideales symmetrisches Verhalten der Kennlinie zu sehen, aber auch im negativen Spannungsbereich wird eine Erhöhung der Stromdichte um einige Größenordnungen erreicht, was zeigt, dass auch eine Injektion von Löchern von der Aluminium Kathode 90 aus möglich ist.
5) Leitfähigkeitssubstrate werden mit den in Beispiel 4 erwähnten dotierten Materialien (M1, K1-2, K1-5 und K1-10) beschichtet. Aus diesen Leitfähigkeitssubstraten wurden insgesamt 9 verschieden dimensionierte Bauteile erzeugt. Hierdurch wird zur Bestimmung der Leitfähigkeit ausgeschlossen, dass die gemessenen Effekte abhängig sind von der Dicke und Fläche der Bauelemente. Für diesen Substrattyp ist es nicht erforderlich, eine Gegenelektrode aus Aluminium aufzubringen.
   Die so erzeugten Bauelemente ergeben die Leitfähigkeit der Schicht, die für die hier gewählten Dotierkonzentrationen die folgenden spezifischen Werte aufweisen:
   M1: 9,10e-9 S/m
   K1-2: 1,81e-6 S/m
   K1-5: 1,86e-6 S/m
   K1-10: 2,15e-6 S/m.

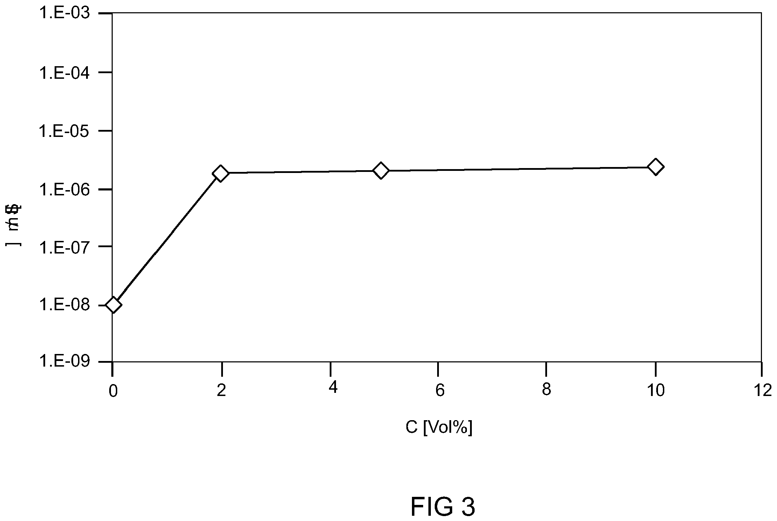

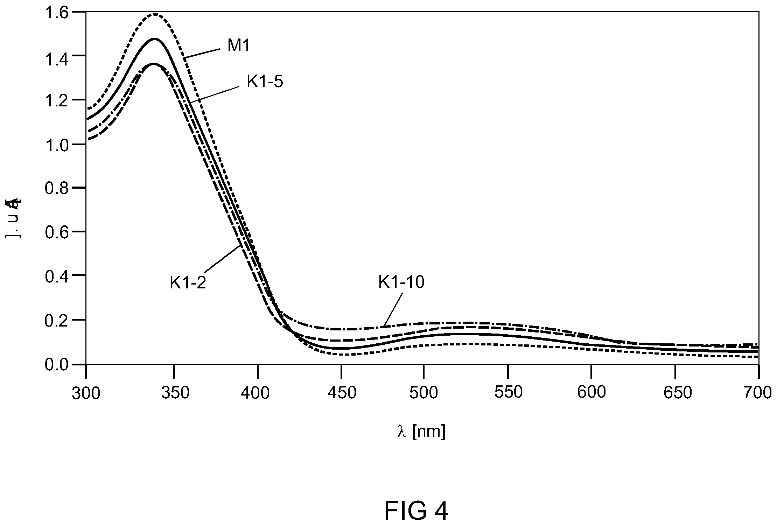

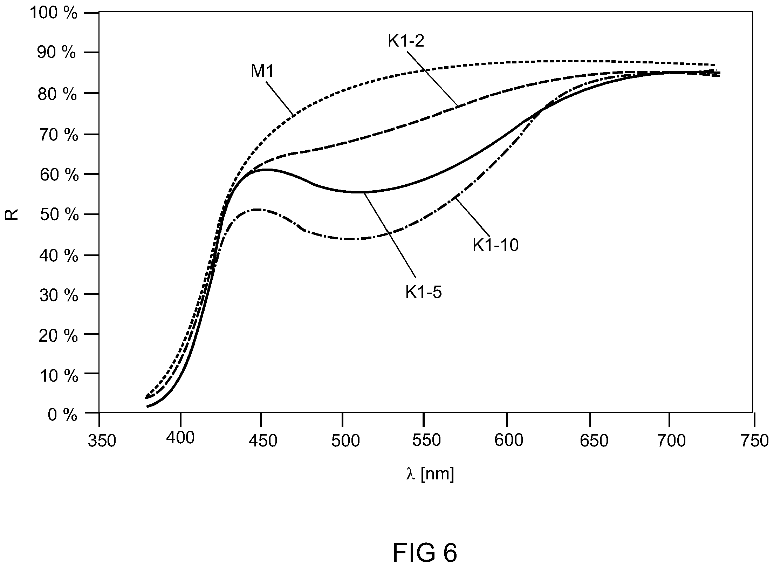

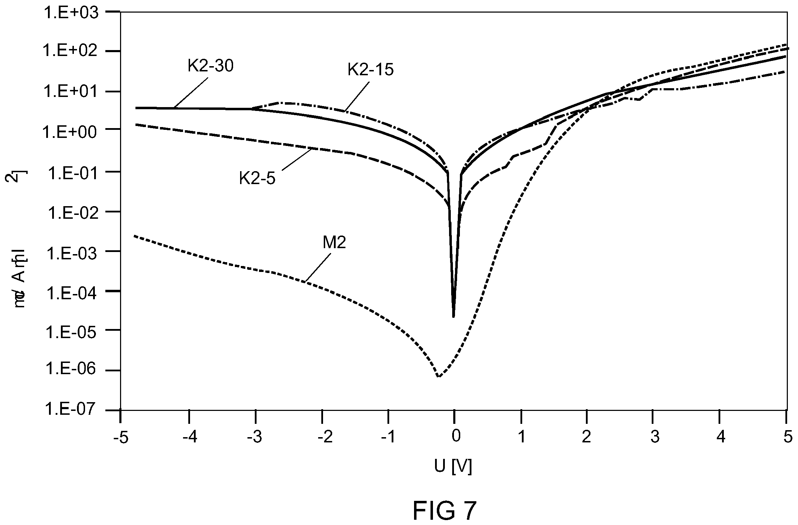

   Figur 3 zeigt die gemessenen Leitfähigkeiten L in [S/m] über der Dotierstoffkonzentration C in [Vol%]. Der gezeigte Verlauf bestätigt hierbei auch die in Figur 2 gezeigten Kennlinien. Die Leitfähigkeit erreicht bei 5% Konzentration ihr Maximum, wobei die gemessenen Leitfähigkeiten von 2% bis 10% sehr ähnliche und fast konstante Leitfähigkeiten aufweisen. Für eine mögliche Anwendung ergibt sich damit ein relativ großes Prozessfenster für die Dotierstoffkonzentration, ohne deren elektrische Leitfähigkeit zu beeinflussen.
6) Die in Beispiel 4 hergestellten Materialien (M1, K1-2, K1-5 und K1-10) werden jeweils auf einer Quarzglasscheibe abgeschieden. Diese Proben besitzen keine elektrischen Kontakte und dienen nur zur Messung von Absorptions-, Emissions- und Reflexionsspektren der einzelnen Schichten.
   Die Absorptionsspektren gemäß Figur 4 (hier ist die Absorption A in [a.u.] gegen die Wellenlänge λ in [nm] aufgetragen) zeigen, dass die absolute Absorption im Absorptionsmaximum bei 340 nm Wellenlänge bei den dotierten Proben im Vergleich zu dem undotierten Vergleichsbeispiel M1 abfällt. Der absolute Abfall liegt hier bei K1-2 und K1-10 etwa auf dem gleichen Level, während der Abfall bei 5% Dotierstoffkonzentration (K1-5) geringer ausfällt.
   Die Absorption des Matrixmaterials 1-TNATA unterhalb von 400 nm wird also gesenkt durch die Formung der dotierten Schicht und der damit verbundenen Bildung eines Charge-Transfer Komplexes.
   Gleichzeitig kommt es aber zu einem Anstieg der Absorption zwischen 440 nm und 600 nm. Dies zeigt ebenfalls die Bildung eines Charge-Transfer Komplexes und einer erfolgreichen Dotierung. Hierbei zeigt sich weiterhin, dass der Anstieg der Absorption in diesem Bereich mit steigender Dotierstoffkonzentration zunimmt. Das Absorptionsspektrum passt daher sehr gut zu den Ergebnissen der Leitfähigkeitsmessungen und der IV-Kennlinien, die in den Figuren 3 und 2 gezeigt sind.
   Für den sichtbaren Wellenlängenbereich von 400 bis 700 nm steigt also die Absorption im blauen bis grünen Wellenlängenbereich wodurch die mit dem p-Dotierstoff dotierten Schichten für das menschliche Auge rötlich erscheinen.

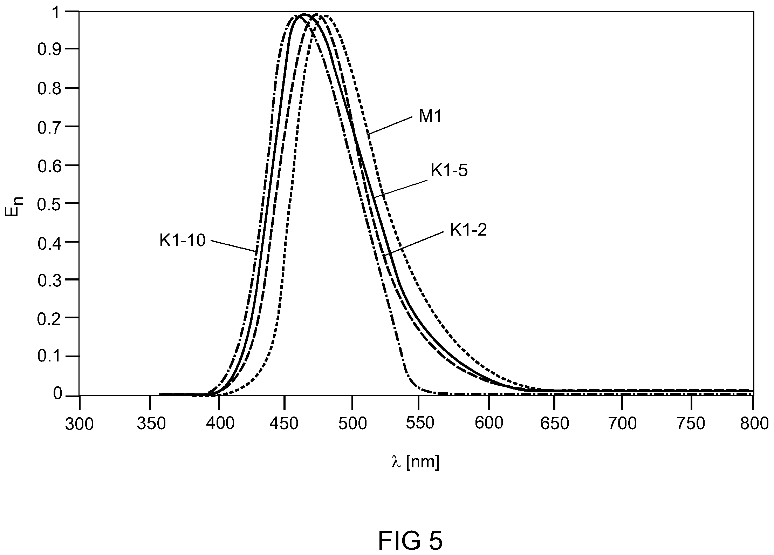

   Figur 5 zeigt die Photolumineszenz (PL)-Spektren der oben genannten Proben. Es ist die normierte Emission Eₙ gegen die Wellenlänge λ in [nm] aufgetragen.
   Der Vergleich der PL-Spektren von undotiertem 1-TNATA (M1) und mit K1 dotiertem 1-TNATA (K1-2, K1-5, K1-10) zeigt, dass sich die vom 1-TNATA übliche Emission bei einer Wellenlänge von 487 nm über 477 nm für 2% Dotierstoffkonzentration auf 463 nm für 5% und 10% Dotierstoffkonzentration verschiebt. Der prinzipielle Verlauf der Emission bleibt erhalten, wobei sich die absolute Emission von 1-TNATA mit eindotiertem K1 verringert.
   Die Reflexionsspektra in Figur 6, in denen die Reflexion R gegen die Wellenlänge λ in [nm] aufgetragen ist, zeigen ebenfalls die bereits mit dem Absorptionsspektrum in Figur 4 gezeigten Informationen. Mit steigender Dotierstoffkonzentration fällt die Reflexion im blau-grünen Wellenlängenbereich (440 bis 600 nm) und bleibt im roten Bereich erhalten. Wiederum ist die Abhängigkeit von der Dotierstoffkonzentration vorhanden und die Reflexion im blau-grünen Bereich nimmt mit steigender Dotierstoffkonzentration immer weiter ab. Optisch ist dies auch an den Substraten zu sehen, deren Farbton für das menschliche Auge mit steigender Konzentration immer dunkler und roter wird.
7) Auf einer ITO Elektrode 10 wird durch thermisches Verdampfen eine 200 nm dicke Schicht des Lochleiters HTM-014 (ein Triarylaminderivat der Firma Merck) abgeschieden (M2). Als Gelegenelektrode 90 diente eine 150 nm dicke Aluminiumschicht. In drei weiteren Experimenten wurde der Dotierstoff K2 in Konzentrationen von 5% (K2-5), 15% (K2-15) und 30% (K2-30) relativ zur Verdampfungsrate in das Matrixmaterial eindotiert.
   Ein 4 mm² großes Bauelement ergibt jeweils die in Figur 7 gezeigten Strom-Spannungs-Kennlinien (IV-Kennlinie). Das Bauelement mit 5% Konzentration ergab dabei die mit K2-5 gekennzeichnete Kennlinie, das Bauelement mit 15% Konzentration die durch K2-15 markierte Kennlinie und das Bauelement mit 30% Konzentration die mit K2-30 gekennzeichnete Kennlinie.
   Für alle Konzentrationen kann gezeigt werden, dass die Dotierung einen Effekt auf die IV-Kennlinie hat.
   Es zeigt sich für alle 3 Konzentrationen ein Anstieg der Stromdichten im Bereich von -5V bis 1.5V zum Referenz-Bauteil M2 aus reinem HTM014. Hierbei zeigt sich weiterhin, dass der Dotiereffekt abhängig ist von der Dotierstoffkonzentration und bei 15% Konzentration die höchste Stromdichte erreicht. Es ist zwar kein ideales symmetrisches Verhalten der Kennlinie zu sehen, aber auch im negativen Spannungsbereich wird eine Erhöhung der Stromdichte um einige Größenordnungen erreicht, was zeigt, das auch eine Injektion von Ladungsträgern von der Aluminium Kathode 90 aus möglich ist.
   Die maximale Stromdichte erhöht sich im Vergleich zum Referenzbauteil (M2) nicht, aber es kommt zu einer Spannungsreduktion bzw. Stromdichtenerhöhung besonders für kleine Spannung im Bereich 0V bis 1V.
8) Die in Beispiel 7 hergestellten Materialien (M2, K2-5, K2-15 und K2-30) werden auf Leitfähigkeitssubstrate beschichtet. Aus diesen Leitfähigkeitssubstraten wurden insgesamt 9 verschieden dimensionierte Bauteile erzeugt. Hierdurch wird zur Bestimmung der Leitfähigkeit ausgeschlossen, dass die gemessenen Effekte abhängig sind von der Dicke und Fläche der Bauelemente. Für diesen Substrattyp ist es nicht erforderlich, eine Gegenelektrode aus Aluminium aufzubringen.
   Die so erzeugten Bauelemente ergeben die Leitfähigkeit der Schicht, die für die hier gewählten Dotierkonzentrationen die folgenden spezifischen Werte aufweisen:
   K2-5: 3,45e-6 S/m
   K2-15: 1,06e-6 S/m
   K2-30: 1,45e-6 S/m

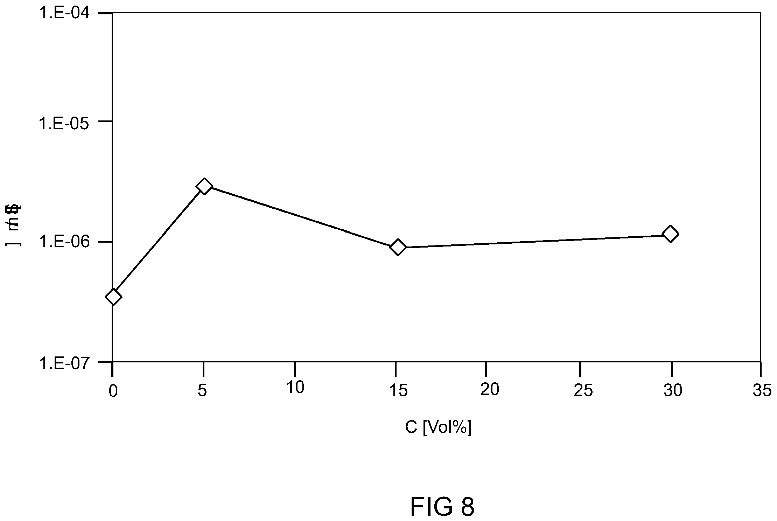

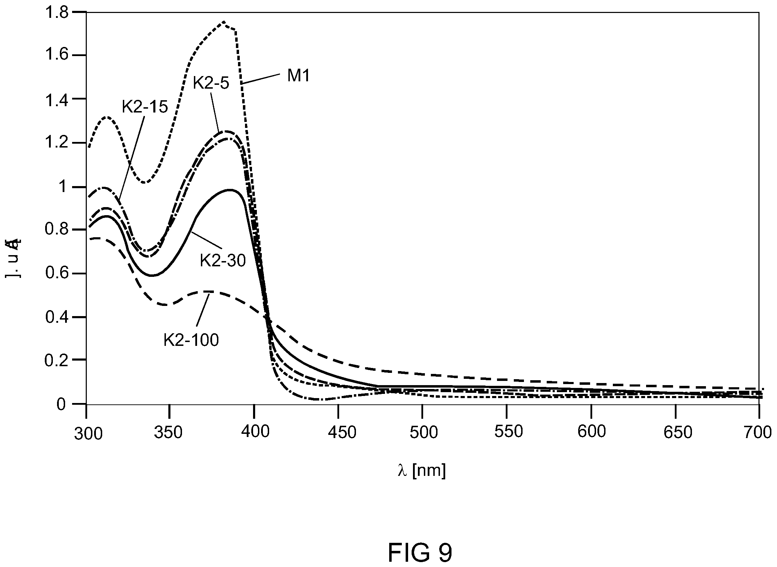

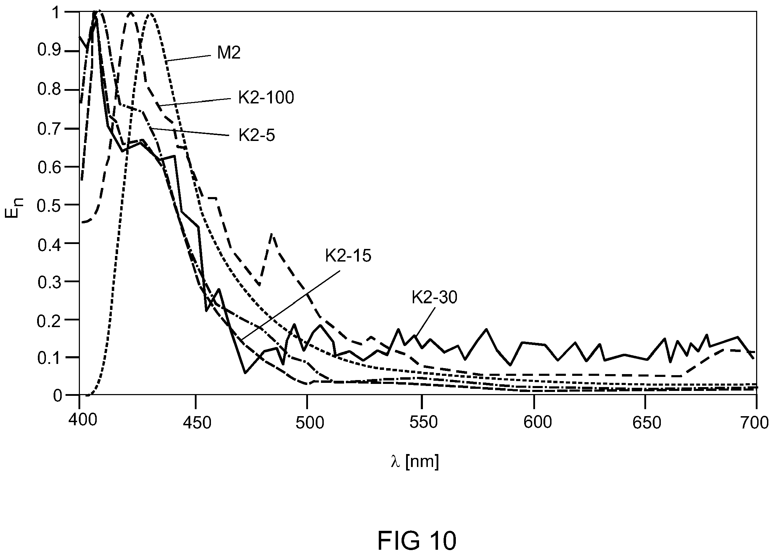

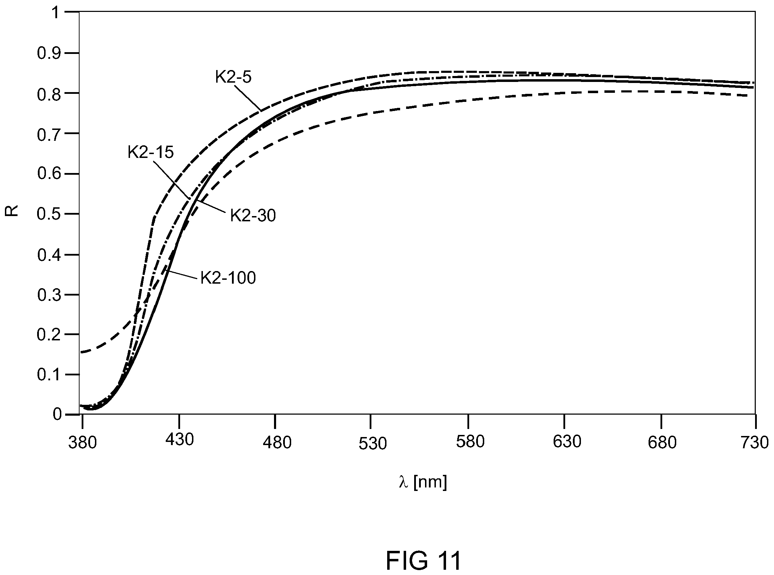

   Figur 8 zeigt die gemessenen Leitfähigkeiten L in [S/m]über der Dotierstoffkonzentration C in Vol%. Der Verlauf zeigt eine Verbesserung der Leitfähigkeit um ein bis zwei Größenordnungen. Das Maximum liegt hierbei bei einer Konzentration von 5% (K2-5), wobei die Leitfähigkeiten für 15% und 30% (K2-15 und K2-30) unter Berücksichtigung von Prozess- und Messschwankungen sehr ähnlich sind und damit fast von einer konstante Leitfähigkeiten gesprochen werden kann. Für eine mögliche Anwendung ergibt sich damit ein relativ großes Prozessfenster für die Dotierstoffkonzentration, ohne deren elektrische Leitfähigkeit zu beeinflussen.
9) Die in Beispiel 7 hergestellten Schichten (M2, K2-5, K3-15 und K2-30) werden zusätzlich jeweils auf einer Quarzglasscheibe abgeschieden. Diese Proben besitzen keine elektrischen Kontakte und dienen nur zur Messung von Absorptions-, Emissions- und Reflexionsspektra der einzelnen Schichten. Zusätzlich wurde hierzu eine Probe mit gleicher Dicke (200 nm) aus reinem K2 (K2-100) erzeugt, um auch hiervon die optischen Daten zu ermitteln.
   Die Absorptionsspektren (Figur 9, Absorption A in [a.u.] gegen die Wellenlänge λ in [nm]) zeigen, dass die absolute Absorption A im Absorptionsmaximum bei 380 nm Wellenlänge abfällt. Der absolute Abfall liegt hier bei 5% (K2-5) und 15% (K2-15) Konzentration etwa auf dem gleichen Level, während der Abfall bei 30% Dotierstoffkonzentration (K2-30) größer ausfällt. Die reine 100% Schicht (K2-100) weist eine nochmals geringere Konzentration auf.
   Die Absorption des reinen Matrixmaterials (M2) unterhalb von 400 nm wird also gesenkt durch die Formung der dotierten Schicht und der damit verbundenen Bildung eines Charge-Transfer Komplexes. Gleichzeitig kommt es aber zu einem Anstieg der Absorption A zwischen 440 nm und 550 nm für die dotierten Schichten. Dies zeigt ebenfalls die Bildung eines Charge-Transfer Komplexes und einer erfolgreichen Dotierung. Hierbei zeigt sich weiterhin, dass der Anstieg der Absorption in diesem Bereich mit steigender Dotierstoffkonzentration zunimmt. Das Absorptionsspektrum passt daher sehr gut zu den Ergebnissen der Leitfähigkeitsmessungen und der IV-Kennlinien aus den Figuren 8 und 7.
   Für den sichtbaren Wellenlängenbereich von 400 bis 700 nm steigt also die Absorption im blauen bis grünen Wellenlängenbereich, wodurch die Schichten für das menschliche Auge rötlich erscheinen. Die Absorption der reinen K2 Schicht (K2-100) liegt über dem gesamten sichtbaren Wellenlängenbereich höher als die dotierten und undotierten Schichten.
   Der Vergleich der Photolumineszenz-Spektren in Figur 10, in der die normierte Emission Eₙ gegen die Wellenlänge λ in [nm] aufgetragen ist, von undotiertem Matrixmaterial (M2) und mit K2 dotiertem Matrixmaterial zeigt, dass sich die von dem Matrixmaterial übliche Emission bei einer Wellenlänge von 432 nm für alle dotierten Schichten auf 406 bis 408 nm verschiebt. Der prinzipielle Verlauf der Emission bleibt erhalten, wobei sich die absolute Emission von HTM-014 mit eindotiertem K2 verringert. Zusätzlich bildet sich eine Schulter bei 432 nm für alle dotierten Schichten. Das Verhalten der K2-30 Probe im Bereich 480 bis 700 nm ist hierbei keine Eigenschaft des Materials, sondern ein Messartefakt aufgrund der geringen Gesamtemission dieser Probe. Die absoluten Emissionen der Schichten sind hierbei nicht berücksichtigt, sondern alle Emissionsspektren für sich normiert.
   Die reine K2 Schicht (K2-100) besitzt ihr Emissionsmaximum bei 423 nm mit einem Nebenmaximum bei 485 nm.
   Die Reflexionsspektren, die in Figur 11 (Reflexion R gegen Wellenlänge λ in [nm]) gezeigt sind, zeigen ebenfalls die bereits mit dem Absorptionsspektrum in Figur 9 gezeigten Informationen. Mit steigender Dotierstoffkonzentration fällt die Reflexion im blau-grünen Wellenlängenbereich (400 bis 580 nm) und bleibt im roten Bereich erhalten. Wiederum ist die Abhängigkeit von der Dotierstoffkonzentration vorhanden und die Reflexion im blau-grünen Bereich nimmt mit steigender Dotierstoffkonzentration immer weiter ab. Optisch ist dies auch an den Substraten zu sehen, deren Farbton für das menschliche Auge mit steigender Konzentration immer dunkler werden. Ebenfalls bestätigt wird, dass die reine p-Dotierstoff Schicht (K2-100) für Wellenlängen unterhalb von 400 nm eine geringere Absorption A und damit höhere Reflexion R aufweist. Im gesamten Wellenlängenbereich und besonders im Bereich 450 nm bis 630 nm liegt die Reflexion deutlich geringer als die der dotierten Schichten.
   Die folgenden Beispiele 10) bis 13) zeigen weitere Ausführungsbeispiele für die p-Dotierstoffe:
10) Ein weiteres Beispiel für einen p-Dotierstoff, der gemäß dem oben genannten Verfahren aus 3,5-Difluorosalicylaldehyd und Pentafluoroanilin hergestellt werden kann, ist in seiner cis- und trans-Form in den Formeln Va und Vb dargestellt: 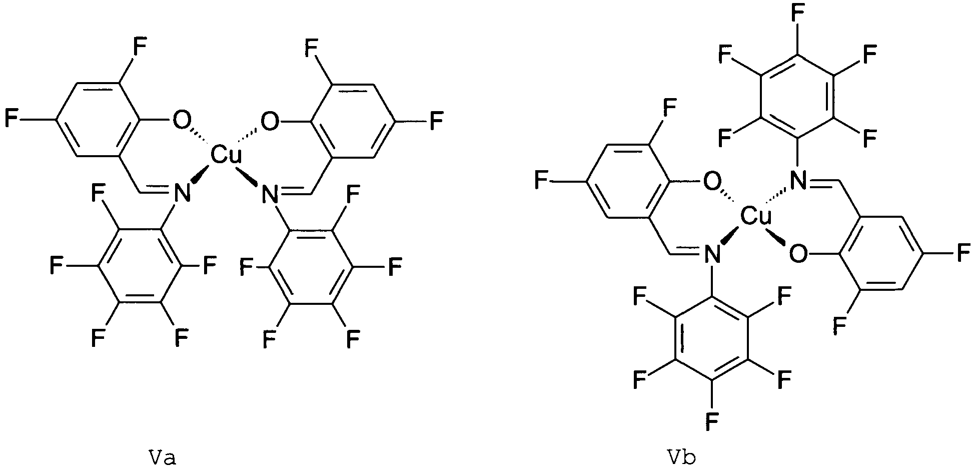
11) Alternativ zu Pentafluoroanilin in Beispiel 13) können auch die Tetrafluoroanilinderivate 2,3,4,5-Tetrafluoroanilin, 2,3,4,6-Tetrafluoroanilin oder 2,3,5,6-Tetrafluoroanilin bzw. die Tri-, Di- oder Monofluoroanliniderivate verwendet werden.
12) Weitere Anilinderivate, die in dem oben genannten Verfahren eingesetzt werden können, sind Trifluormethylgruppen oder Derivate, die zusätzlich FluorSubstituenten aufweisen, beispielsweise 2-Fluoro-3-(trifluoromethyl)anilin, 2-Fluoro-4-(trifluoromethyl)anilin, 2-Fluoro-5-trifluoromethylanilin, 2-Fluoro-6-(trifluoromethyl)anilin, 3-Fluoro-2-(trifluoromethyl)anilin, 3-Fluoro-4-(trifluoromethyl)anilin, 3-Fluoro-5-(trifluoromethyl)anilin, 4-Fluoro-2-(trifluoromethyl)anilin, 4-Fluoro-3-(trifluoromethyl)anilin, 5-Fluoro-2-trifluoromethylanilin.
13) Als Salicylaldehyde können zur Herstellung des p-Dotierstoffs auch 4-(Trifluoromethyl)salicylaldehyd oder 4-(Trifluoromethoxy)salicylaldehyd eingesetzt werden.

## Patentansprüche

1. Organisches elektronisches Bauelement umfassend
- ein Substrat (10),
- eine erste Elektrode (20) auf dem Substrat (10),
- zumindest eine organische Funktionsschicht (30), die ein Matrixmaterial, in dem ein p-Dotierstoff eingebracht ist, enthält, auf der ersten Elektrode (20), und
- eine zweite Elektrode (90) auf der zumindest einen organischen Funktionsschicht (30),
- wobei der p-Dotierstoff einen Kupferkomplex umfasst, der zumindest einen Liganden aufweist, der eine Aryloxygruppe und eine Iminiumgruppe enthält,
wobei die Aryloxygruppe und die Iminiumgruppe des Liganden eine Salicylaldiminatgruppe sind.

2. Bauelement nach dem vorhergehenden Anspruch,
wobei der Kupferkomplex eine der allgemeinen Formeln I oder II aufweist: 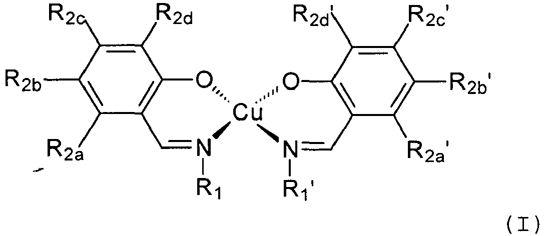 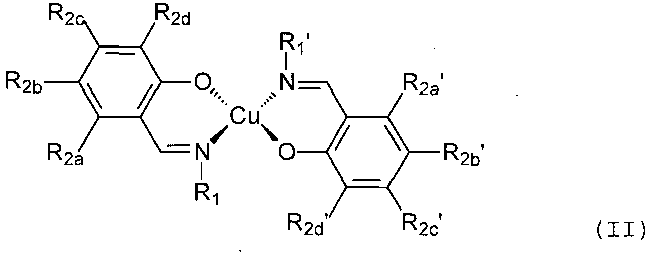 wobei
R₁, R_{1'}, R₂ₓ, R_{2x'} mit x = a, b, c oder d, unabhängig voneinander ausgewählt sind aus einer Gruppe, die unverzweigte, verzweigte, kondensierte, ringförmige, unsubstituierte und substituierte Alkylreste, substituierte und unsubstituierte Aromaten, substituierte und unsubstituierte Heteroaromaten umfasst.

3. Bauelement nach einem der vorhergehenden Ansprüche,
wobei die Aryloxygruppe und die Iminiumgruppe des Liganden eine Salicylaldiminatgruppe sind.

4. Bauelement nach einem der vorhergehenden Ansprüche, wobei der Kupferkomplex ein Kupferkation der Oxidationsstufe II enthält.

5. Bauelement nach dem vorhergehenden Anspruch, wobei R₁ und R_{1'}, R₂ₓ und R_{2x'} jeweils gleich sind.

6. Bauelement nach einem der Ansprüche 4 oder 5, wobei R₁ und R_{1'} miteinander verbunden sind.

7. Bauelement nach einem der Ansprüche 4 bis 6, wobei zumindest einer aus R₁, R_{1'}, R₂ₓ und R_{2x'} einen elektronenziehenden Substituenten aufweist.

8. Bauelement nach einem der vorhergehenden Ansprüche, wobei die zumindest eine organische Funktionsschicht (30) Loch leitend ist.

9. Bauelement nach einem der vorhergehenden Ansprüche, wobei das Matrixmaterial ein Lochtransportmaterial ist, das organische kleine Moleküle, Polymere oder Mischungen daraus umfasst.

10. Bauelement nach einem der vorhergehenden Ansprüche, wobei Moleküle des p-Dotierstoffs jeweils von mindestens einem Molekül des Matrixmaterials koordiniert sind.

11. Bauelement nach einem der vorhergehenden Ansprüche, wobei der p-Dotierstoff in einer Konzentration von 0,1 bis 50 Vol% in dem Matrixmaterial vorhanden ist.

12. Bauelement nach einem der vorhergehenden Ansprüche, das aus einer Gruppe ausgewählt ist, die Feldeffekttransistoren, Solarzellen, Photodetektoren, optoelektronische Bauelemente, Licht emittierende Dioden und Displays umfasst.

13. Bauelement nach einem der vorhergehenden Ansprüche, wobei die Funktionsschicht als Lochtransportschicht und/oder als lochleitende Teilschicht einer ladungserzeugenden Schichtfolge ausgeformt ist.

14. Verwendung eines Kupferkomplexes, der zumindest einen Liganden aufweist, der eine Aryloxygruppe und eine Iminiumgruppe enthält, als p-Dotierstoff in einem Lochtransportmaterial, wobei die Aryloxygruppe und die Iminiumgruppe des Liganden eine Salicylaldiminatgruppe sind.

15. Verfahren zur Herstellung eines p-Dotierstoffs, der einen Kupferkomplex mit zumindest einem Liganden, der eine Aryloxygruppe und eine Iminiumgruppe enthält, umfasst, bei dem der zumindest eine Ligand synthetisiert wird und gleichzeitig ein Kupferkation komplexiert wird, wobei die Aryloxygruppe und die Iminiumgruppe des Liganden eine Salicylaldiminatgruppe sind.

## Claims

1. An organic electronic component comprising
- a substrate (10),
- a first electrode (20) on the substrate (10),
- at least one organic functional layer (30) comprising a matrix material, into which a p-type dopant has been introduced, on the first electrode (20), and
- a second electrode (90) on the at least one organic functional layer (30),
- wherein the p-type dopant comprises a copper complex, which comprises at least one ligand which comprises an aryloxy group and an iminium group,
wherein the aryloxy group and the iminium group of the ligand are a salicylaldiminate group.

2. The component according to the preceding claim, wherein the copper complex has one of the general formulae I or II: 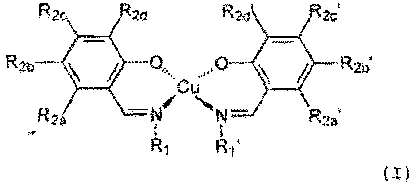 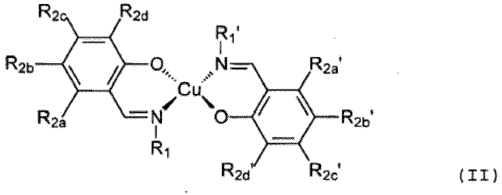 where
R₁, R_{1'}, R₂ₓ, R_{2x'} where x = a, b, c or d are each independently selected from a group comprising unbranched, branched, fused, cyclic, unsubstituted and substituted alkyl radicals, substituted and unsubstituted aromatics, substituted and unsubstituted heteroaromatics.

3. The component according to one of the preceding claims, wherein the aryloxy group and the iminium group of the ligand are a salicylaldiminate group.

4. The component according to one of the preceding claims, wherein the copper complex contains a copper cation of the oxidation stage II.

5. The component according to the preceding claim, wherein R₁ and R_{1'}, R₂ₓ and R_{2x'} are each identical.

6. The component according to one of claims 4 or 5, wherein R₁ and R_{1'} are connected to one another.

7. The component according to one of claims 4 to 6, wherein at least one of R₁, R_{1'}, R₂ₓ and R_{2x'} has an electron- withdrawing substituent.

8. The component according to one of the preceding claims, wherein the at least one organic functional layer (30) is hole-conductive.

9. The component according to one of the preceding claims, wherein the matrix material is a hole-transport material, which comprises organic small molecules, polymers or mixtures thereof.

10. The component according to one of the preceding claims, wherein molecules of the p-type dopant are each coordinated by at least one molecule of the matrix material.

11. The component according to one of the preceding claims, wherein the p-type dopant is present in the matrix material in a concentration of 0.1 to 50% by volume.

12. The component according to one of the preceding claims, which is selected from a group consisting of field effect transistors, solar cells, photodetectors, optoelectronic components, light-emitting diodes and displays.

13. The component according to one of the preceding claims, wherein the functional layer is formed as a hole-transport layer and/or as a hole-conducting partial layer of a charge-generating layer sequence.

14. The use of a copper complex which has at least one ligand which comprises an aryloxy group and an iminium group, as a p-type dopant in a hole-transport material, wherein the aryloxy group and the iminium group of the ligand are a salicylaldiminate group.

15. A method for producing a p-type dopant which comprises a copper complex having at least one ligand, which comprises an aryloxy group and an iminium group, in which the at least one ligand is synthesized and at the same time a copper cation is complexed, wherein the aryloxy group and the iminium group of the ligand are a salicylaldiminate group.

## Revendications

1. Composant électronique organique comprenant
- un substrat (10),
- une première électrode (20) sur le substrat (10),
- au moins une couche fonctionnelle (30) organique qui contient une matière matricielle dans laquelle est introduit un agent de dopage p, sur la première électrode (20), et
- une deuxième électrode (90) sur l'au moins une couche fonctionnelle (30) organique,
- l'agent de dopage p comprenant un complexe de cuivre qui présente au moins un ligand qui contient un groupe aryloxy et un groupe iminium,
le groupe aryloxy et le groupe d'iminium du ligand étant un groupe salicyl aldiminate.

2. Composant selon la revendication précédente,
le complexe de cuivre présentant une des formules générales I ou II 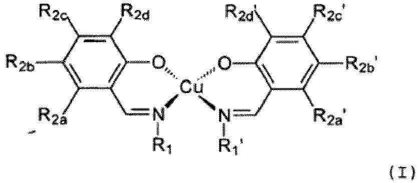 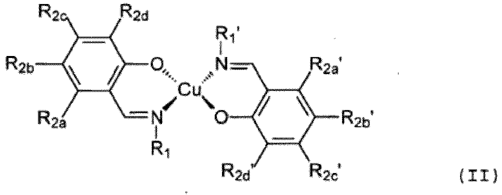 où
R₁, R_{1'}, R₂ₓ, R_{2x'} avec x = a, b, c, ou d, étant sélectionnés indépendamment les uns des autres à partir d'un groupe comprenant des radicaux alkyle non ramifiés, ramifiés, condensés, annulaires, non substitués et substitués, des aromates substitués et non substitués et des hétéro-aromates substitués et non substitués.

3. Composant selon l'une quelconque des revendications précédentes,
le groupe aryloxy et le groupe iminium du ligand étant un groupe salicyl aldiminate.

4. Composant selon l'une quelconque des revendications précédentes,
le complexe de cuivre contenant un cation de cuivre de l'état d'oxydation II.

5. Composant selon la revendication précédente, R₁ et R_{1'}, R₂ₓ et R_{2x'} étant respectivement identiques.

6. Composant selon l'une quelconque des revendications 4 ou 5, R₁ et R_{1'} étant reliés entre eux.

7. Composant selon l'une quelconque des revendications 4 à 6, au moins un parmi R₁, R_{1'}, R₂ₓ, R_{2x'} présentant un substituant attracteur d'électrons.

8. Composant selon l'une quelconque des revendications précédentes, l'au moins une couche fonctionnelle (30) organique transportant les trous.

9. Composant selon l'une quelconque des revendications précédentes,
la matière matricielle étant une matière de transport de trous, laquelle comprend des petites molécules organiques, des polymères ou des mélanges de ceux-ci.

10. Composant selon l'une quelconque des revendications précédentes,
les molécules de l'agent de dopage p étant respectivement coordonnées par au moins une molécule de la matière matricielle.

11. Composant selon l'une quelconque des revendications précédentes,
l'agent de dopage p étant présent dans une concentration de 0,1 à 50% en volume dans la matière matricielle.

12. Composant selon l'une quelconque des revendications précédentes,
lequel est sélectionné dans un groupe qui comprend des transistors à effet de champ, des cellules solaires, des photodétecteurs, des composants optoélectroniques, des diodes émettrices de lumière et des affichages.

13. Composant selon l'une quelconque des revendications précédentes,
la couche fonctionnelle étant formée comme couche de transport de trous et/ou comme couche partielle de transport de trous d'une succession de couches générant une charge.

14. Utilisation d'un complexe de cuivre qui présente au moins un ligand qui contient un groupe aryloxy et un groupe iminium, en tant qu'agent de dopage p dans une matière de transport de trous, le groupe aryloxy et le groupe iminium du ligand étant un groupe salicyl aldiminate.

15. Procédé de fabrication d'un agent de dopage p qui contient un complexe de cuivre ayant au moins un ligand qui contient un groupe aryloxy et un groupe iminium, dans lequel l'au moins un ligand est synthétisé et un cation de cuivre est simultanément complexé, le groupe aryloxy et le groupe iminium du ligand étant un groupe salicyl aldiminate.
